# EUROPEAN PATENT APPLICATION

(11) **EP 4 472 376 A1**
(43) Date of publication of application: **04.12.2024**
(21) Application number: 23746609.9
(22) Date of filing: 05.01.2023
(51) Int. Cl.: H05K 9/00, C01G 49/00, C08J 5/00, H01F 1/11

(54) **RADIO WAVE ABSORBER AND RADIO WAVE ABSORBING ARTICLE**

(30) Priority: 26.01.2022 JP 2022009892
(71) Applicant: FUJIFILM Corporation, Tokyo 106-8620 (JP)
(72) Inventor: HASHIMOTO, Hirokazu, Minamiashigara-shi, Kanagawa 250-0193 (JP)
(74) Representative: Klunker IP Patentanwälte PartG mbB
(86) International application number: PCT/JP2023/000048
(87) International publication number: WO 2023/145392

(57) **Abstract**

There are provided a radio wave absorber containing a magnetic powder and a binder, in which an inclination of a peak frequency with respect to a temperature is 40.0 MHz/°C or less, and a radio wave absorbing article including this radio wave absorber.

## Description

### BACKGROUND OF THE INVENTION

### Field of the Invention

The present invention relates to a radio wave absorber and a radio wave absorbing article.

### Description of the Related Art

A radio wave absorber containing a magnetic powder as the radio wave absorption material is known (see, for example, PTL1 and PTL2).

### Citation List

### Patent Literature

PTL1: JP4674380B
PTL2: JP2019-145534A

### SUMMARY OF THE INVENTION

In recent years, as an electronic device that uses radio waves, a radar for recognizing an object by transmitting and receiving radio waves has attracted attention. For example, an on-vehicle radar transmits radio waves and receives radio waves which are the transmitted radio waves reflected by an object (such as a pedestrian, a vehicle, or the like), whereby it can recognize the presence of the object, the distance to the object, or the like. In order to prevent collision with an object, as necessary, an automatic driving control system of an automobile can automatically brake and stop the automobile or can automatically control the speed to keep the distance to the object based on the results obtained by the radar recognizing the object.

In order to improve the reliability of the system that carries out various controls based on the results obtained by the radar recognizing the object as described above, it is desired to improve the performance of the radar. For this reason, in recent years, it has begun to be examined to install a radio wave absorber on the front side (an incident side of the radio wave incident from the outside) of the radio wave transmitting and receiving unit of the radar to improve the recognition accuracy.

It is desired that the radio wave absorber has excellent radio wave absorbability. From the viewpoint of improving the radio wave absorbability, a radio wave absorber having excellent transmission attenuation characteristics is desirable, for example, from the viewpoint of improving the recognition accuracy of a radar. In addition, also in various other use applications in which a radio wave absorber is used, a radio wave absorber having excellent transmission attenuation characteristics is desirable. With regard to this point, further improvement is desired in the radio wave absorber in the related art.

In consideration of the above circumstances, an object of an aspect according to the present invention is to provide a radio wave absorber having excellent transmission attenuation characteristics.

An aspect of the present invention is as follows.
[1] A radio wave absorber comprising:
   a magnetic powder; and
   a binder,
   in which an inclination of a peak frequency with respect to a temperature is 40.0 megahertzs (MHz)/°C or less.
[2] The radio wave absorber according to [1], in which a volume filling rate of the magnetic powder in the radio wave absorber is 35% by volume or less.
[3] The radio wave absorber according to [1] or [2], in which an elastic modulus is 500 MPa or less.
[4] The radio wave absorber according to any one of [1] to [3], in which the magnetic powder includes a powder of a hexagonal ferrite.
[5] The radio wave absorber according to [4], in which the hexagonal ferrite is a substitution-type hexagonal ferrite.
[6] The radio wave absorber according to [5], in which the substitution-type hexagonal ferrite is a magnetoplumbite-type hexagonal ferrite having a composition represented by Formula 1,

   Formula 1 AFe₍₁₂₋ₓ₎AlₓO₁₉

   in Formula 1, A represents one or more kinds of atoms selected from the group consisting of Sr, Ba, Ca, and Pb, and x satisfies 0.50 ≤ x ≤ 8.00.
[7] The radio wave absorber according to [6], in which an atom represented by A in Formula 1 includes Sr.
[8] A radio wave absorbing article comprising:
   the radio wave absorber according to any one of [1] to [7].

According to one aspect of the present invention, it is possible to provide a radio wave absorber having excellent transmission attenuation characteristics. In addition, according to one aspect of the present invention, it is possible to provide a radio wave absorbing article including the radio wave absorber.

### DESCRIPTION OF THE PREFERRED EMBODIMENTS

### [Radio wave absorber]

One aspect of the present invention relates to a radio wave absorber containing a magnetic powder and a binder, in which an inclination of a peak frequency with respect to a temperature is 40.0 megahertzs (MHz)/°C or less.

In the present invention and the present specification, the term "radio wave" means an electromagnetic wave having a frequency of 3 terahertz (THz) or less. The "radio wave absorber" has radio wave absorbability. The radio wave absorbability can be evaluated, for example, by a transmission attenuation amount, the details of which will be described later.

In the present invention and the present specification, the term "powder" means an aggregation of a plurality of particles. The term "aggregation" is not limited to a form in which particles that constitute an aggregation are in direct contact with each other, and also includes a form in which a binder described later or the like is interposed between the particles.

### inclination of peak frequency with respect to temperature>

In the present invention and the present specification, the term "the inclination of the peak frequency with respect to the temperature" regarding the radio wave absorber is a value determined according to the following method.

The radio wave absorber as a measurement target is subjected to measurement at each of six different measurement temperatures of "-20°C", "+23°C", "+40°C", "+60°C", "+80°C", and "+100°C", and the transmission attenuation amount at each measurement temperature is determined. In a case where the radio wave absorber as a measurement target is subjected to measurement at the above-described six measurement temperatures, the measurement order is not limited. The above-described measurement temperature is a temperature of the radio wave absorber as a measurement target. The temperature of the radio wave absorber as a measurement target is adjusted to the measurement temperature before the measurement. Such a temperature adjustment can be carried out by cooling the radio wave absorber with a cooling means such as liquid nitrogen, regarding "-20°C" described above and "-30°C" described later. Regarding the other temperatures, it is possible to adjust the temperature by controlling an atmospheric temperature of an environment in which the radio wave absorber is disposed, or by using a heating means such as a heater as necessary. The temperature adjustment is sufficiently carried out until the temperature of the entire radio wave absorber as a measurement target reaches the measurement temperature. The measurement is carried out at room temperature, and the measurement of the transmission attenuation amount is completed within 1 minute after the above-described temperature adjustment has been carried out. The points described above also apply to the measurement of the reflection attenuation amount described later. In the present invention and the present specification, the term "room temperature" means a temperature in a range of 20°C to 27°C unless otherwise specified. The "transmission attenuation amount" in the present invention and the present specification is a value that is determined as S21 of an S parameter, where the S parameter is measured according to a free space method under conditions of an incidence angle of 0°, a sweep frequency of 60 gigahertzs (GHz) to 90 GHz, and a sweep interval of 0.05 GHz. The measurement can be carried out using a publicly known vector network analyzer and horn antenna. Examples of the specific example of the measurement method include the methods described in the section of Examples described later.

From the measurement results obtained from the measurement at each measurement temperature, the frequency at which the transmission attenuation amount is maximized is determined. Such a frequency is defined as the "peak frequency".

In this way, the peak frequency is obtained for each of the six measurement temperatures. An inclination a of a linear function "y = ax + b" (y is the peak frequency, x is the measurement temperature, a is the inclination, and b is the intercept) is calculated according to the least squares method from the obtained values. The inclination a that is calculated in this way is defined as "the inclination of the peak frequency with respect to the temperature".

In the radio wave absorber, the inclination of the peak frequency with respect to the temperature is 40.0 MHz/°C or less. As a result of diligent studies to obtain a radio wave absorber having excellent transmission attenuation characteristics, the inventors of the present invention found that in a radio wave absorber in which the inclination of the peak frequency, which is determined as described above, is 40.0 MHz/°C or less with respect to the temperature, variations in transmission attenuation characteristics in association with temperature change are small, and thus favorable transmission attenuation characteristics can be exhibited in a wide temperature range. From the viewpoint of further improving the transmission attenuation characteristics, the inclination of the peak frequency with respect to the temperature of the radio wave absorber is preferably 39.0 MHz/°C or lower, more preferably 38.0 MHz/°C or lower, still more preferably 37.0 MHz/°C or lower, even still more preferably 36.0 MHz/°C or lower, and even further still more preferably 35.0 MHz/°C or lower. The inclination of the peak frequency with respect to the temperature of the radio wave absorber can be, for example, 0 MHz/°C or more or more than 0 MHz/°C, and it can also be 1.0 MHz/°C or more, 5.0 MHz/°C or more, 10.0 MHz/°C or more, 15.0 MHz/°C or more, 20.0 MHz/°C or more, 25.0 MHz/°C or more, or 30.0 MHz/°C or more. From the viewpoint of further improving the transmission attenuation characteristics, the smaller the inclination of the peak frequency with respect to the temperature of the radio wave absorber is, the more preferable it is. The above-described inclination of the peak frequency with respect to the temperature can be controlled, for example, by adjusting the preparation conditions of the magnetic powder. This point will be described below in detail.

From the viewpoint of further improving the radio wave absorbability, it is more preferable that the radio wave absorber can exhibit a high transmission attenuation amount in a wide temperature range. From this point, it is preferable that in the radio wave absorber, transmission attenuation amounts at a frequency of 76.5 GHz are all 15.0 dB or more, where the transmission attenuation amounts are measured at measurement temperatures of "-30°C", "+25°C", and "+80°C", respectively. Such a transmission attenuation amount can be, for example, 30.0 dB or less, 25.0 dB or less, or 20.0 dB or less, or it can exceed the values exemplified here. Such a transmission attenuation amount can be controlled by the proportion of the magnetic powder in the radio wave absorber, the thickness of the radio wave absorber, the kind of the magnetic powder, and the like.

### <Volume filling rate of magnetic powder>

The radio wave absorber contains a magnetic powder and a binder. The filling rate of the magnetic powder in the radio wave absorber is not particularly limited. In one form, the filling rate can be 35% by volume or less and can also be, for example, in a range of 15% to 35% by volume in terms of the volume filling rate. In addition, in another form, the volume filling rate can be 35% by volume or more. In this case, the volume filling rate can be, for example, in a range of 35% to 60% by volume, and it can also be in a range of 35% to 50% by volume. The volume filling rate means a volume-based content with respect to the total volume (100% by volume) of the radio wave absorber.

For example, the magnetic powder is collected from the radio wave absorber by a publicly known method, and the volume filling rate of the magnetic powder in the radio wave absorber can be determined as "(the volume of the collected magnetic powder/the total volume of the radio wave absorber) × 100". Here, the total volume of the radio wave absorber and the volume of the magnetic powder can be determined by a publicly known method. Alternatively, in a case where the composition of the composition used for preparing a radio wave absorber is known, the volume filling rate of the magnetic powder in the radio wave absorber can be determined from this known composition.

In addition, the volume filling rate of the magnetic powder in the radio wave absorber can also be determined by the following method using a cross-section SEM image acquired by a scanning electron microscope (SEM).

A measurement sample having a square plane, one side of which has a length of 5 mm, is cut out from a randomly determined position of the radio wave absorber as a measurement target. A sample for cross-section observation is prepared from the cut-out sample. The sample for cross-section observation is prepared by focused ion beam (FIB) processing. The prepared cross-section observation sample is observed by SEM, and a cross-section image (SEM image) is captured. As the SEM, a field emission-scanning electron microscope (FE-SEM) is used. Using the FE-SEM, a cross-section observation sample is set on a stage so that the FIB-processed cross-section faces upward, and a cross-section SEM image with a visual field of 30 µm × 40 µm is obtained under the conditions of an acceleration voltage of 15 kV and an observation magnification of 3,000 folds. The obtained cross-section SEM image is subjected to binarization processing, and the proportion (in terms of the area) of the magnetic powder is calculated.

The above operation is carried out on five measurement samples cut out from different positions of the radio wave absorber as a measurement target, and the volume filling rate of the magnetic powder can be determined as the arithmetic average of the obtained five values. It is noted that, as necessary, the elemental analysis of the cross-section observation sample is carried out to specify the portion of the magnetic powder in the cross-section SEM image.

The volume filling rates of the other components described in the present specification can also be determined in the same manner as described above.

Regarding the radio wave absorber, a radio wave absorber that exhibits excellent reflection attenuation characteristics in addition to the transmission attenuation characteristics can be said to be a radio wave absorber that exhibits more excellent radio wave absorbability. From the viewpoint of improving the reflection attenuation characteristics, the volume filling rate of the magnetic powder in the radio wave absorber is preferably 35% by volume or less, more preferably 34% by volume or less, and still more preferably 33% by volume or less, 32% by volume or less, 31% by volume or less, and 30% by volume or less in this order. As described above, the volume filling rate of the magnetic powder in the radio wave absorber can be, for example, 15% by volume or more. In addition, from the viewpoint of controlling the reflection attenuation amount, the volume filling rate of the magnetic powder in the radio wave absorber is preferably 10% by volume or more, more preferably 12% by volume or more, and still more preferably 15% by volume or more.

### <Shape retention>

Even from the viewpoint of the shape retention of the radio wave absorber, the volume filling rate of the magnetic powder in the radio wave absorber is preferably 35% by volume or less, more preferably 34% by volume or less, and still more preferably 33% by volume or less, 32% by volume or less, 31% by volume or less, and 30% by volume or less in this order. Regarding the shape retention, it can be said that the more difficult the radio wave absorber is deformed due to the weight thereof, the more excellent the shape retention is. A radio wave absorber having excellent shape retention is preferable, since the shape change hardly occurs, for example, in a case of being incorporated into a radio wave absorbing article and then used.

Examples of the indicator of the shape retention include a "deflection amount" that is determined according to the following test method, with reference to the experimental method related to deflection, which is described in paragraph 0122 of WO2017/085808A.

A test piece is cut out from each of three randomly selected locations in the radio wave absorber as a measurement target, and the deflection amount of each test piece is determined. The arithmetic average of the three measured values obtained in this way is defined as the deflection amount of the radio wave absorber as a measurement target. The test piece has a thickness of 2 mm, a length of 100 mm, and a width of 10 mm. It is noted that in a case where the thickness of the radio wave absorber as a measurement target is less than 2 mm, the radio wave absorber as a measurement target needs only to be subjected to, for example, processing into a pellet shape and then press molding to prepare a test piece having a thickness of 2 mm. This point also applies to a case where the length of the radio wave absorber as a measurement target is less than 100 mm and a case where the width of the radio wave absorber as a measurement target is less than 10 mm.

One end part of the test piece is fixed to a fixing jig using a publicly known fixing means such as a double-sided tape. A terminal of the test piece on the fixed side is set to a position of 0 mm, a terminal opposite to the fixed side is set to a position of 100 mm, and a fixing range in which the test piece is fixed to the fixing jig is set in a range from the position of 0 mm to a position of 20 mm. For example, in a case where a double-sided tape is used as the fixing means, a weight may be installed at the upper part of the test piece in the fixing range in order to prevent the double-sided tape from being peeled off. The fixing of the test piece to the fixing jig is carried out in a room temperature atmosphere.

The test piece in a state of being fixed to the fixing jig in this way is disposed in a test environment having an atmospheric temperature of 80°C, and then the deflection amount is determined for the deflection which occurs in 72 hours. The deflection amount is a vertical positional variation amount of a terminal of the end part on a side opposite to the terminal part fixed to the fixing jig. The vertical position (initial position) of the end part is measured within 1 minute after the disposition in the test environment. 72 hours after the measurement of the initial position, the test piece in a state of being fixed to the fixing jig is taken out from the test environment and then allowed to stand in a room temperature atmosphere. At a timing when one hour has passed after taking out the test piece from the test environment, the vertical position (variation position) of the terminal is measured in a room temperature atmosphere. The above measurement can be carried out with a publicly known measurement device such as a laser displacement meter. The deflection amount is determined as a variation amount of the variation position from the initial position.

From the viewpoint of shape retention, the deflection amount in the radio wave absorber is preferably 8.0 mm or less, more preferably 7.5 mm or less, and still more preferably 7.0 mm or less. The deflection amount may be, for example, 3.0 mm or more, 4.0 mm or more, or 5.0 mm or more, and it may be lower than the values exemplified here. The smaller the value of the deflection amount, the more preferable from the viewpoint of shape retention.

### <Reflection attenuation characteristics>

With regard to the reflection attenuation characteristics of the radio wave absorber, the reflection attenuation amount at a frequency of 76.5 GHz at a measurement temperature of "+25°C" is preferably 8.0 dB or more, more preferably 8.5 dB or more, and still more preferably 9.0 dB or more. The reflection attenuation amount can be, for example, 18.0 dB or less, 17.0 dB or less, 16.0 dB or less, 15.0 dB or less, 13.0 dB or less, or 12.0 dB or less.

In the present invention and the present specification, the reflection attenuation amount at a frequency of 76.5 GHz at a measurement temperature of "+25°C" is a value determined according to the following method.

A radio wave absorber as a measurement target is subjected to a measurement at a measurement temperature of "+25°C" to determine the reflection attenuation amount. The measurement temperature is as described above. The "reflection attenuation amount" in the present invention and the present specification is a value that is determined as S11 of an S parameter at a frequency of 76.5 GHz, where the S parameter is measured according to a free space method under conditions of an incidence angle of 0°, a sweep frequency of 60 GHz to 90 GHz, and a sweep interval of 0.05 GHz. The measurement can be carried out using a publicly known vector network analyzer and horn antenna. Examples of the specific example of the measurement method include the methods described in the section of Examples described later.

By the way, in a radio wave absorber, a metal layer may be laminated on a surface (a so-called back surface) opposite to the surface on which radio waves are incident on the radio wave absorber. Such a radio wave absorber is called a matching-type radio wave absorber. In the matching-type radio wave absorber, reflection attenuation characteristics can be enhanced by providing a metal layer to utilize the phase difference absorption. On the other hand, in one form, in the radio wave absorber, the radio wave absorber itself can have excellent reflection attenuation characteristics. Specifically, it is possible to exhibit a high reflection attenuation amount regardless of the metal layer. A radio wave absorber that is used without laminating a metal layer on the back surface is generally called a transmission-type radio wave absorber. In the transmission-type radio wave absorber in the related art which contains a magnetic powder and a binder, in general, the reflection attenuation amount tended to decrease in a case where an attempt was made to increase the transmission attenuation amount. On the other hand, in one form, the radio wave absorber can exhibit a high reflection attenuation amount and a high transmission attenuation amount regardless of the metal layer.

The "metal layer" described in the present specification means a layer containing a metal and substantially reflecting radio waves. However, in a case where the radio wave absorber containing a magnetic powder and a binder contains a metal, such a radio wave absorber does not correspond to the metal layer. Here, the phase "substantially reflecting radio waves" means, for example, reflecting 90% or more of incident radio waves in a case where the radio waves are incident on the radio wave absorber in a state where a metal layer is laminated on the back surface of the radio wave absorber. Examples of the form of the metal layer include a metal plate and a metal foil. For example, a metal layer formed on the back surface of the radio wave absorber by vapor deposition can be mentioned. The radio wave absorber can be used without a metal layer being provided on the back surface. The fact that the radio wave absorber can be used without a metal layer is preferable from the viewpoint of recycling and the viewpoint of cost. In addition, the quality of the radio wave absorber that is used by laminating a metal layer on the back surface may deteriorate due to the deterioration of the metal layer, the peeling of the metal layer from the radio wave absorber. The fact that it can be used without a metal layer being provided on the back surface is also preferable in that such quality deterioration does not occur.

### <Restorability>

Examples of the performance desired for the radio wave absorber also include excellent restorability. Specifically, the restorability is shape restorability. For example, in a case where a radio wave absorber is incorporated into a radio wave absorbing article and then used, a radio wave absorber having excellent restorability is preferable, since damage hardly occurs even in a case where the radio wave absorbing article is subjected to an impact due to a collision or the like. Examples of the indicator of restorability include "tensile strain set at constant elongation" that is required by a test for tensile strain set at constant elongation, where the test is specified in JIS K 6273: 2018. With regard to a shape and dimensions of a test piece to be subjected to the measurement of the tensile strain set at constant elongation, the test piece is set to an ISO dumbbell test piece 1A type defined in ISO527-1: 2012. For the elongation imparted to the test piece, "(20.0 ± 2.0)%" described in section 5.3.5 of JIS K 6273: 2018 is employed. In the present invention and the present specification, the "tensile strain set at constant elongation" determined in this way shall be referred to as "20% tensile permanent strain". In the radio wave absorber, the 20% tensile permanent strain is preferably 1.8% or less, more preferably 1.7% or less, and still more preferably 1.5% or less. A radio wave absorber that exhibits a 20% tensile permanent strain in the above-described range is preferable since it has excellent restorability. The 20% tensile permanent strain of the radio wave absorber can be, for example, 0% or more, more than 0%, 0.5% or more, 0.8% or more, or 1.2% or more. The smaller the value of the 20% tensile permanent strain, the more preferable from the viewpoint of restorability.

### <Elastic modulus>

From the viewpoint of improving restorability, it is preferable that the elastic modulus of the radio wave absorber is low. In the present invention and the present specification, the term "elastic modulus" is a tensile modulus defined in ISO 527-1: 2012. With regard to a shape and dimensions of a test piece to be subjected to the measurement of the elastic modulus, the test piece is set to an ISO dumbbell test piece 1A type defined in ISO527-1: 2012. A tensile test is carried out at a tensile speed of 10 mm/min, and the elastic modulus is calculated by linear regression between the elongation rates of 0.05% to 0.25%. As a tensile tester, for example, a tensile tester AGX-V manufactured by Shimadzu Corporation can be used. Five test pieces are cut out from the radio wave absorber as a measurement target, and the elastic modulus is determined for each of the test pieces. The arithmetic average of the five measured values determined in this way is defined as the elastic modulus of the radio wave absorber as a measurement target.

The elastic modulus of the radio wave absorber is preferably 500 megapascals (MPa) or less, more preferably 450 MPa or less, still more preferably 400 MPa or less, and even still more preferably 350 MPa or less. A radio wave absorber that exhibits an elastic modulus in the above-described range is preferable since it has excellent restorability. The elastic modulus of the radio wave absorber can be, for example, 100 MPa or more, 150 MPa or more, or 200 MPa or more. From the viewpoint of restorability, the smaller the value of the elastic modulus is, the more preferable it is. Regarding the elastic modulus of the radio wave absorber, the elastic modulus tends to increase in a case where the volume filling rate of the magnetic powder in the radio wave absorber is high.

### <Magnetic powder>

Examples of the magnetic powder contained in the radio wave absorber include powders of various magnetic materials such as ferrite, iron oxide, cobalt, and chromium oxide. The radio wave absorber may contain only one kind of magnetic powder or may contain two or more kinds of magnetic powders in any ratio. From the viewpoint of radio wave absorbability, the magnetic powder is preferably a powder of a hexagonal ferrite. The kind of the magnetic material that constitutes the magnetic powder contained in the radio wave absorber can be checked by extracting the magnetic powder from the radio wave absorber according to a publicly known method and carrying out an analysis according to the X-ray diffraction method on the extracted magnetic powder. Alternatively, it can be checked by, for example, the following method. A part or all of the radio wave absorber is finely chopped, immersed in a solvent (for example, hexafluoroisopropanol) for 1 or 2 days, and then dried. The dried radio wave absorber is further ground finely and subjected to an analysis according to the X-ray diffraction method.

### <<Powder of hexagonal ferrite>>

In the present invention and the present specification, the term "powder of a hexagonal ferrite" refers to a magnetic powder in which a crystal structure of a hexagonal ferrite is detected as the main phase by an analysis according to the X-ray diffraction method. The main phase refers to a structure to which the highest intensity diffraction peak attributes in the X-ray diffraction spectrum are obtained according to the X-ray diffraction method. For example, in a case where the highest intensity diffraction peak is attributed to a hexagonal ferrite crystal structure in an X-ray diffraction spectrum obtained by the X-ray diffraction method, it is determined that the hexagonal ferrite crystal structure is detected as the main phase. In a case where only a single structure is detected according to the X-ray diffraction method, this detected structure is used as the main phase. The hexagonal ferrite crystal structure includes at least an iron atom, a divalent metal atom, and an oxygen atom, as a constituent atom. In the unsubstitution-type hexagonal ferrite, the atoms that constitute the crystal structure of the hexagonal ferrite are only the iron atom, the divalent metal atom, and the oxygen atom. On the other hand, the substitution-type hexagonal ferrite contains one or more kinds of other atoms together with the iron atom, the divalent metal atom, and the oxygen atom, as atoms that constitute the crystal structure of the hexagonal ferrite. These one or more kinds of other atoms are generally atoms that are substituted for a part of iron in the crystal structure of hexagonal ferrite. The divalent metal atom is a metal atom that is capable of being a divalent cation, as an ion, and examples thereof include an alkaline earth metal atom such as a strontium atom, a barium atom, or a calcium atom, and a lead atom. In the present invention and the present specification, the hexagonal strontium ferrite powder means one in which the main divalent metal atom contained in this powder is a strontium atom, and the hexagonal barium ferrite powder means one in which the main divalent metal atom contained in this powder is a barium atom. The same applies to other kinds of powders of the hexagonal ferrite. The main divalent metal atom means a divalent metal atom that occupies the largest amount among the divalent metal atoms contained in this powder in terms of % by atom. However, rare earth atoms shall not be included in the above divalent metal atoms. The "rare earth atom" in the present invention and the present specification is selected from the group consisting of a scandium atom (Sc), a yttrium atom (Y), and a lanthanoid atom. The lanthanoid atom is selected from the group consisting of a lanthanum atom (La), a cerium atom (Ce), a praseodymium atom (Pr), a neodymium atom (Nd), a promethium atom (Pm), a samarium atom (Sm), a europium atom (Eu), a gadolinium atom (Gd), a terbium atom (Tb), a dysprosium atom (Dy), a holmium atom (Ho), an erbium atom (Er), a thulium atom (Tm), a ytterbium atom (Yb), and a lutetium atom (Lu).

Regarding the powder of the hexagonal ferrite powder, the hexagonal ferrite that constitutes the powder includes one or more kinds of hexagonal ferrites selected from the group consisting of hexagonal strontium ferrite, hexagonal barium ferrite, hexagonal calcium ferrite, and hexagonal lead ferrite. From the viewpoint of the radio wave absorbability in the high frequency band, it is preferably one or more kinds of hexagonal ferrites selected from the group consisting of hexagonal strontium ferrite, hexagonal barium ferrite, and hexagonal calcium ferrite, more preferably hexagonal strontium ferrite and/or hexagonal barium ferrite, and still more preferably hexagonal strontium ferrite.

In one form, the powder of a hexagonal ferrite contained in the radio wave absorber can be a magnetoplumbite-type (generally referred to as an "M-type") powder of a hexagonal ferrite. The magnetoplumbite-type hexagonal ferrite has a composition represented by a composition formula: AFe₁₂O₁₉ in a case of being an unsubstitution-type which does not contain an atom that substitutes iron. Here, A can represent one or more kinds of atoms selected from the group consisting of Sr, Ba, Ca, and Pb, and also includes a form in which two or more of these atoms are contained in any ratio.

The hexagonal ferrite that is preferable from the viewpoint of radio wave absorbability includes, for example, a substitution-type hexagonal ferrite. Specific examples of the substitution-type hexagonal ferrite include a substitution-type magnetoplumbite-type hexagonal ferrite in which a part of iron atoms of the magnetoplumbite-type hexagonal ferrite are substituted with an aluminum atom. As one form of such hexagonal ferrite, hexagonal ferrite having a composition represented by Formula 1 can be mentioned.

Formula 1 AFe₍₁₂₋ₓ₎AlₓO₁₉

In Formula 1, A represents one or more kinds of atoms (hereinafter, also referred to as an "A atom") selected from the group consisting of Sr, Ba, Ca, and Pb, it may be only one kind of atom, it may contain two or more kinds of atoms in any ratio, and, from the viewpoint of improving the uniformity of the composition between particles that constitute the powder, it is preferably only one kind of atom.

From the viewpoint of the radio wave absorbability in the high frequency band, A in Formula 1 is preferably one or more kinds of atoms selected from the group consisting of Sr, Ba, and Ca, and more preferably one or more kinds of atoms selected from the group consisting of Sr and Ba. It is still more preferable that Sr is contained, and it is even still more preferable that A is Sr.

In Formula 1, x satisfies 0.50 ≤ x ≤ 8.00.

In one form, x can satisfy 1.50 ≤ x ≤ 8.00. From the viewpoint of the radio wave absorbability in the high frequency band, x is preferably 1.50 or more, more preferably more than 1.50, still more preferably 2.00 or more, and even still more preferably more than 2.00. In addition, from the viewpoint of magnetic properties, x is 8.00 or less, preferably less than 8.00, more preferably 6.00 or less, and still more preferably less than 6.00.

Specific examples of the form which is the substitution-type hexagonal ferrite represented by Formula 1 belonging to a magnetoplumbite type and in which x satisfies 1.50 ≤ x ≤ 8.00 include SrFe_{(9.58)}Al_{(2.42)}O₁₉, SrFe_{(9.37)}Al_{(2.63)}O₁₉, SrFe_{(9.27)}Al_{(2.73)}O₁₉, SrFe_{(9.85)}Al_{(2.15)}O₁₉, SrFe_{(10.00)}Al_{(2.00)}O₁₉, SrFe_{(9.74)}Al_{(2.26)}O₁₉, SrFe_{(10.44)}Al_{(1.56)}O₁₉, SrFe_{(9.79)}Al_{(2.21)}O₁₉, SrFe_{(9.33)}Al_{(2.67)}O₁₉, SrFe_{(7.88)}Al_{(4.12)}O₁₉, SrFe_{(7.04)}Al_{(4.96)}O₁₉, SrFe_{(7.37)}Al_{(4.63)}O₁₉, SrFe_{(6.25)}Al_{(5.75)}O₁₉, SrFe_{(7.71)}Al_{(4.29)}O₁₉, Sr_{(0.80)}Ba_{(0.10)}Ca_{(0.10)}Fe_{(9.83)}Al_{(2.17)}O₁₉, BaFe_{(9.50)}Al_{(2.50)}O₁₉, CaFe_{(10.00)}Al_{(2.00)}O₁₉, and PbFe_{(9.00)}Al_{(3.00)}O₁₉. In addition, specific examples thereof also include the substitution-type hexagonal strontium ferrite described in the section of Examples described later. The composition of the magnetic powder can be confirmed, for example, by subjecting a dissolution solution in which the magnetic powder is dissolved, to a high frequency inductively coupled plasma emission spectroscopic analysis. Specific examples of the checking method include a method described in the section of Examples described later. Alternatively, after exposing a cross-section by cutting the radio wave absorber or the like, the exposed cross-section is subjected to, for example, energy dispersive X-ray analysis, whereby the composition of the magnetic powder contained in the radio wave absorber can be checked.

In addition, in one form, x can satisfy 0.50 ≤ x < 1.50. For example, from the viewpoint of the radio wave absorbability in a high frequency band in a range of 35.0 GHz to 66.0 GHz, preferably 45.0 GHz to 66.0 GHz, and more preferably 55.0 GHz to 66.0 GHz, x can be set to 0.50 or more, and x is preferably more than 0.80. In addition, from the viewpoint of magnetic properties, x is preferably less than 1.50 and more preferably 1.20 or less.

In one form, in the powder of the substitution-type hexagonal ferrite, the crystal phase can be a single phase, and a plurality of crystal phases can be included. It is preferable that the crystal phase is a single phase, and it is more preferable that the powder of the hexagonal ferrite is a powder of a substitution-type hexagonal ferrite of which the substitution type is a magnetoplumbite type in which the crystal phase is a single phase.

The case where the "crystal phase is a single phase" refers to a case where only one kind of diffraction pattern showing any crystal structure is observed in an analysis carried out according to the X-ray diffraction method. The analysis according to the X-ray diffraction method can be carried out, for example, according to the method described in the section of Examples described later. In a case where a plurality of crystal phases are included, two or more kinds of diffraction patterns showing any crystal structure are observed in the analysis according to the X-ray diffraction method. Regarding the attribution of the diffraction pattern, for example, a database of the International Centre for Diffraction Data (ICDD, registered trade name) can be referenced. For example, regarding the diffraction pattern of the magnetoplumbite-type hexagonal ferrite containing Sr, "00-033-1340" of the International Centre for Diffraction Data (ICDD) can be referred to. However, in a case where a part of iron atoms are substituted with a substituent atom such as an aluminum atom, the peak position shifts from the peak position in a case where the substituent atom is not included.

### (Production method for powder of hexagonal ferrite)

There are various methods as the production method for a powder of a hexagonal ferrite, and the production method for a powder of a hexagonal ferrite is not particularly limited in a case where the radio wave absorber contains a powder of a hexagonal ferrite. Hereinafter, a solid phase method will be described as one example of the production method for a powder of a hexagonal ferrite. The solid phase method is a production method for a powder of a hexagonal ferrite by sintering a mixture obtained by mixing a plurality of solid raw materials.

Examples of the solid raw material that is used in the solid phase method include a compound of an iron atom and a compound of an A atom, and further include a compound of a substituent atom in a case of producing a powder of a substitution-type hexagonal ferrite. These compounds can be an oxide, a carbonate, or the like. The A atom and the substituent atom are as described above. The mixing ratio between a plurality of solid raw materials may be determined according to the desired hexagonal ferrite composition. A raw material mixture can be obtained by mixing a plurality of solid raw materials at the same time or sequentially mixing them in any order. In addition, the mixing of solid raw materials is not limited to being carried out under dry conditions. Under wet conditions, for example, a solvent such as water may be added, and mixing may be carried out in a slurry state. The mixing of the solid raw materials can be carried out by a commercially available mixing device or a mixing device having a publicly known configuration. One example of the mixing device is a paint shaker. As the mixing conditions are reinforced, the value of the inclination of the peak frequency with respect to the temperature described above tends to decrease. One example of a means for reinforcing the mixing conditions is the use of dispersion media such as dispersion beads. The above mixing can be carried out, for example, in an ambient air atmosphere at room temperature.

After the above mixing, the obtained raw material mixture can be sintered. In this sintering, the crystallization of the raw material mixture can be promoted, whereby the crystal structure of the hexagonal ferrite can be formed. Regarding the sintering conditions, the sintering temperature can be set, for example, in a range of 1,000°C to 1,500°C. The sintering temperature can be, for example, the atmosphere temperature inside the device in which sintering is carried out (for example, the temperature inside the heating furnace). The sintering time can be in a range of 1 hour to 6 hours. However, the above-described ranges are described as examples, and the sintering may be carried out under conditions under which the crystal structure of the hexagonal ferrite is capable of being formed. The sintering can be carried out, for example, in an ambient air atmosphere.

In the sintering, it is also possible to add a fusing agent to the powder of the raw material mixture and sinter it. As the fusing agent, various fusing agents can be used, and examples thereof include SrCl₂, SrCl₂·6H₂O, CaCl₂·2H₂O, MgCl₂, KCl, NaCl, BaCl₂·2H₂O, and Na₂B₄O₇. The adding amount thereof is, for example, preferably 0.1 to 10 parts by mass and more preferably 0.1 to 8.0 parts by mass with respect to 100 parts by mass of the powder of the raw material mixture.

The raw material mixture before sintering can be subjected to a dry-type or wet-type pulverization step, and/or the sintered product after the sintering can be subjected to a dry-type or wet-type pulverization step. In a case of carrying out the pulverization step, it is possible to adjust the size of the particles that constitute the powder of the hexagonal ferrite. The pulverization can be carried out with a publicly known pulverizing unit such as a mortar and pestle or a pulverizer (a cutter mill, a ball mill, a bead mill, a roller mill, a jet mill, a hammer mill, an attritor, or the like). As the pulverization conditions are reinforced, the value of the inclination of the peak frequency with respect to the temperature described above tends to increase.

The sintered product obtained after the sintering can be subjected to a step such as pulverization, as necessary, and then subjected to an annealing treatment. In a case where the annealing treatment is carried out, the value of the inclination of the peak frequency with respect to the temperature described above tends to decrease. The annealing treatment can be carried out, for example, in a heating furnace having a furnace temperature of 500°C to 1,100°C for about 1 to 10 hours.

One or more publicly known steps such as washing and drying can be optionally carried out before and/or after the various steps described above.

### <Binder>

The radio wave absorber contains a magnetic powder and a binder. The binder can be, for example, a resin, and examples of the resin include a thermoplastic resin and a thermosetting resin.

Examples of the thermoplastic resin include an acrylic resin, polyacetal, polyamide, polyethylene, polypropylene, polyethylene terephthalate, polybutylene terephthalate, a polyethylene terephthalate-1,4-cyclohexanedimethanol terephthalate copolymer, polylactic acid, polycarbonate, polystyrene, polyphenylene sulfide, polyvinyl chloride, an acrylonitrile butadiene styrene (ABS) resin obtained by copolymerization of acrylonitrile, butadiene, and styrene; and an acrylonitrile styrene (AS) resin obtained by copolymerization of acrylonitrile and styrene.

Examples of the thermosetting resin include a phenol resin, an epoxy resin, a melamine resin, a urea resin, an unsaturated polyester, a diallyl phthalate resin, a urethane resin, and a silicon resin.

The binder can also be rubber. From viewpoints that the mixability with the magnetic powder is good and the radio wave absorber having more excellent durability, weather fastness, and impact resistance can be manufactured, examples of the rubber include butadiene rubber, isoprene rubber, chloroprene rubber, halogenated butyl rubber, fluororubber, urethane rubber, acrylic rubber (abbreviation: ACM) obtained by copolymerization of an acrylic acid ester (for example, ethyl acrylate, butyl acrylate, or 2-ethylhexyl acrylate) and another monomer, ethylene-propylene rubber obtained by coordination polymerization of ethylene and propylene using a Ziegler catalyst, butyl rubber (abbreviation: IIR) obtained by copolymerization of isobutylene and isoprene, styrene butadiene rubber (abbreviation: SBR) obtained by copolymerization of butadiene and styrene, acrylonitrile butadiene rubber (abbreviation: NBR) obtained by copolymerization of acrylonitrile and butadiene, and silicone rubber.

In a case where the radio wave absorber of the present disclosure contains rubber as the binder, it may contain various additives such as a vulcanizing agent, a vulcanization aid, a softener, and a plasticizer, in addition to the rubber. Examples of the vulcanizing agent include sulfur, an organic sulfur compound, and a metal oxide.

Examples of the binder include a thermoplastic elastomer (TPE). Examples of the thermoplastic elastomer include an olefin-based thermoplastic elastomer (a thermoplastic olefinic elastomer (TPO)), a styrene-based thermoplastic elastomer (a thermoplastic styrenic elastomer (TPS)), an amide-based thermoplastic elastomer (a thermoplastic polyamide elastomer (TPA), and a polyester-based thermoplastic elastomer (a thermoplastic copolyester (TPC)).

The radio wave absorber may include only one kind of binder and may include two or more kinds thereof. The volume filling rate of the binder in the radio wave absorber is not particularly limited, and it is, for example, preferably 65% by volume or more, more preferably 65% by volume or more and 92% by volume or less, and still more preferably 65% by volume or more and 85% by volume or less. In a case where the radio wave absorber contains two or more kinds of binders, the volume filling rate means the total volume filling rate of the two or more kinds of binders. This point also identically applies to the volume filling rates of other components.

### <Additive>

The radio wave absorber may randomly contain or may not contain one or more additives in any proportion. Examples of the additive include an antioxidant, a light stabilizer, a dispersing agent, a dispersing aid, a fungicide, an antistatic agent, a plasticizer, an impact improver, a crystal nucleating agent, a lubricant, a surfactant, a pigment, a dye, a filler, a mold release agent (fatty acid, a fatty acid metal salt, an oxyfatty acid, a fatty acid ester, an aliphatic partially saponified ester, paraffin, a low molecular weight polyolefin, a fatty acid amide, an alkylenebis fatty acid amide, an aliphatic ketone, a fatty acid lower alcohol ester, a fatty acid polyhydric alcohol ester, a fatty acid polyglycol ester, a modified silicone, and the like), a processing aid, an antifogging agent, a drip inhibitor, and an antibacterial agent. In the additive, one component may have two or more functions.

### (Antioxidant)

In one form, examples of the preferred additive include an antioxidant.

The antioxidant is not particularly limited, and a publicly known antioxidant can be used.

Examples of the antioxidant are described in, for example, "Comprehensive Technology for Polymer Stabilization - Mechanism and Application Development -" published by CMC Publishing Co., Ltd., supervised by Yasukazu Okatsu. This description is incorporated in the present specification by reference.

Examples of the kind of the antioxidant include a phenol-based antioxidant, an amine-based antioxidant, a phosphorus-based antioxidant, and a sulfur-based antioxidant.

As the antioxidant, it is preferable to use a phenol-based antioxidant and/or an amine-based antioxidant in combination with a phosphorus-based antioxidant and/or a sulfur-based antioxidant.

Examples of the phenol-based antioxidant include ADEKA STAB AO-20, ADEKA STAB AO-30, ADEKA STAB AO-40, ADEKA STAB AO-50, ADEKA STAB AO-60, ADEKA STAB AO-80, and ADEKA STAB AO-330, manufactured by ADEKA Corporation; and IRGANOX 1010, IRGANOX 1035, IRGANOX 1076, IRGANOX 1098, IRGANOX 1135, IRGANOX 1330, IRGANOX 1726, IRGANOX 245, IRGANOX 259, IRGANOX 3114, and IRGANOX 565, manufactured by BASF Japan Ltd. It is noted that the above "ADEKA STAB" and "IRGANOX" are both registered trade names.

Examples of the amine-based antioxidants include Sanol LS-770, Sanol LS-765, and Sanol LS-2626, manufactured by Mitsubishi-Chemical Foods Corporation; ADEKA STAB LA-77, ADEKA STAB LA-57, ADEKA STAB LA-52, ADEKA STAB LA-62, ADEKA STAB LA-63, ADEKA STAB LA-67, ADEKA STAB LA-68, and ADEKA STAB LA-72, manufactured by ADEKA Corporation; and TINUVIN 123, TINUVIN 144, TINUVIN 622, TINUVIN 765, and TINUVIN 944, manufactured by BASF Japan Ltd. It is noted that the above "ADEKA STAB" and "TINUVIN" are both registered trade names.

In addition, an amine-based compound capable of quenching radicals can also be used as the antioxidant. Examples of such an amine-based compound include polyethylene glycol bis TEMPO [Sigma-Aldrich Co., LLC] and sebacic acid bis TEMPO. It is noted that "TEMPO" is an abbreviation for tetramethylpiperidin-1-oxyl.

Examples of the phosphorus-based antioxidant include ADEKA STAB PEP-8, ADEKA STAB PEP-36, ADEKA STAB HP-10, and ADEKA STAB 2112, manufactured by ADEKA Corporation; and IRGAFOS 168 manufactured by BASF Japan Ltd. It is noted that the above "ADEKA STAB" and "IRGAFOS" are both registered trade names.

Examples of the sulfur-based antioxidant include ADEKA STAB AO-412S and ADEKA STAB AO-503 S, manufactured by ADEKA Corporation. It is noted that the above "ADEKA STAB" is a registered trade name.

Among the above, the phenol-based antioxidant is preferably at least one selected from the group consisting of ADEKA STAB AO-20, ADEKA STAB AO-60, ADEKA STAB AO-80, and IRGANOX 1010, the amine-based antioxidant is preferably ADEKA STAB LA-52, the phosphorus-based antioxidant is preferably ADEKA STAB PEP-36, and the sulfur-based antioxidant is preferably ADEKA STAB AO-412S.

In a case of containing an antioxidant, the above radio wave absorber may contain only one kind of antioxidant or may contain two or more kinds of antioxidants.

In a case where the above radio wave absorber contains an antioxidant, the content of the antioxidant in the radio wave absorber is not particularly limited, and it is, for example, preferably 0.1 parts by mass to 10 parts by mass and more preferably 0.5 parts by mass to 5 parts by mass with respect to 100 parts by mass of the binder from the viewpoint of both suppressing the decomposition of the binder and suppressing the bleeding of the antioxidant.

### (Light stabilizer)

In one form, examples of the preferred additive include a light stabilizer.

Examples of the light stabilizer include HALS (that is, a hindered amine light stabilizer), an ultraviolet absorbing agent, and a singlet oxygen quencher.

The HALS may be a high molecular weight HALS, a low molecular weight HALS, or a combination of a high molecular weight HALS and a low molecular weight HALS.

In a case of containing a light stabilizer, the above radio wave absorber may contain only one kind of light stabilizer or may contain two or more kinds of light stabilizers.

### - High molecular weight HALS -

In the present invention and the present specification, the term "high molecular weight HALS" means a hindered amine light stabilizer having a weight-average molecular weight of more than 1,000.

Examples of the high molecular weight HALS include, as an oligomer-type HALS, poly [6-(1,1,3,3-tetramethylbutyl)imino-1,3,5-triazine-2,4-diyl] [(2,2,6,6-tetramethyl-4-piperidyl)imino]hexamethylene [(2,2,6,6-tetramethyl-4-piperidyl)imino] and dimethyl succinate-1-(2-hydroxyethyl)-4-hydroxy-2,2,6,6-tetramethylpiperidine polycondensate.

Examples of the commercially available high molecular weight HALS product include CHIMASSORB 944LD and TINUVIN 622LD, manufactured by BASF Japan Ltd. It is noted that the above "CHIMASSORB" and "TINUVIN" are both registered trade names.

The weight-average molecular weight (Mw) in the present invention and the present specification is a value measured according to gel permeation chromatography (GPC). For the measurement using the gel permeation chromatography (GPC), HLC (registered trade name) -8220GPC [manufactured by Tosoh Corporation] is used as the measurement device, TSKgel (registered trade name) Super HZM-M [4.6 mm ID ×15 cm, manufactured by Tosoh Corporation], Super HZ4,000 [4.6 mm ID × 15 cm, manufactured by Tosoh Corporation], Super HZ3,000 [4.6 mm ID × 15 cm, manufactured by Tosoh Corporation], and Super HZ2,000 [4.6 mm ID × 15 cm, manufactured by Tosoh Corporation] are connected one by one in series and used as the column, and tetrahydrofuran (THF) can be used as the eluent.

The measurement conditions can be a sample concentration of 0.2% by mass, a flow rate of 0.35 mL/min, a sample injection amount of 10 µL, and a measurement temperature of 40°C, and a differential refractive index (RI) detector can be used as the detector.

The calibration curve can be created using "Standard sample TSK standard, polystyrene", "F-40", "F-20", "F-4", "F-1", "A-5000", "A-2500", and "A-1000", manufactured by Tosoh Corporation.

In a case where the above radio wave absorber contains a high molecular weight HALS, the content of the high molecular weight HALS in the radio wave absorber is not particularly limited, and it is, for example, preferably 0.2% by mass to 10% by mass with respect to the total mass of the radio wave absorber.

The content of the high molecular weight HALS in the above radio wave absorber is preferably made be 0.2% by mass or more with respect to the total mass of the radio wave absorber from the viewpoint of improving weather fastness.

In a case where the content of the high molecular weight HALS in the radio wave absorber is 10% by mass or less with respect to the total mass of the radio wave absorber, the decrease in mechanical strength and the occurrence of blooming tend to be capable of being suppressed.

### - Low molecular weight HALS -

In the present invention and the present specification, the term "low molecular weight HALS" means a hindered amine light stabilizer having a molecular weight of 1,000 or less (preferably 900 or less and more preferably 600 to 900).

Examples of the low molecular weight HALS include tris(2,2,6,6-tetramethyl-4-piperidyl)benzene-1,3,5-tricarboxylate, tris(2,2,6,6-tetramethyl-4-piperidyl)-2-acetoxypropane-1,2,3-tricarboxylate, tris(2,2,6,6-tetramethyl-4-piperidyl)-2-hydroxypropane-1,2,3-tricarboxylate, tris(2,2,6,6-tetramethyl-4-piperidyl)triazine-2,4,6-tricarboxylate, tris(2,2,6,6-tetramethyl-4-piperidyl)butane-1,2,3-tricarboxylate, tetrakis(2,2,6,6-tetramethyl-4-piperidyl)propane-1,1,2,3-tetracarboxylate, tetrakis(2,2,6,6-tetramethyl-4-piperidyl) 1,2,3,4-butanetetracarboxylate, tetrakis(1,2,2,6,6-pentamethyl-4-piperidyl) 1,2,3,4-butanetetracarboxylate, and 2-(3,5-di-t-butyl-4-hydroxybenzyl)-2-n-butylmalonate bis(1,2,2,6,6-pentamethyl-4-piperidyl).

Examples of the commercially available low molecular weight HALS product include ADEKA STAB LA-57, and ADEKA STAB LA-52, manufactured by ADEKA Corporation; and TINUVIN 144 manufactured by BASF Japan Ltd. It is noted that the above "ADEKA STAB" and "TINUVIN" are both registered trade names.

In a case where the above radio wave absorber contains a low molecular weight HALS, the content of the low molecular weight HALS in the radio wave absorber is not particularly limited; however, it is, for example, preferably 0.2% by mass to 10% by mass with respect to the total mass of the radio wave absorber.

The content of the low molecular weight HALS in the above radio wave absorber is preferably made be 0.2% by mass or more with respect to the total mass of the radio wave absorber from the viewpoint of improving weather fastness.

In a case where the content of the low molecular weight HALS in the radio wave absorber is 10% by mass or less with respect to the total mass of the radio wave absorber, the decrease in mechanical strength and the occurrence of blooming tend to be capable of being suppressed.

### - Ultraviolet absorbing agent -

Examples of the ultraviolet absorbing agent include benzotriazole-based ultraviolet absorbing agents such as 2-(2'-hydroxy-3',5'-di-t-butylphenyl)benzotriazole, 2-(3,5-di-t-amyl-2-hydroxyphenyl)benzotriazole, 2-(2'-hydroxy-5'-methyl-phenyl)benzotriazole, 2-(2'-hydroxy-5'-t-octylphenyl)benzotriazole, 2-(2'-hydroxy-3',5'-di-t-amylphenyl)benzotriazole, 2-[2'-hydroxy-3'-(3",4",5",6"-tetrahydro-phthalimidemethyl)-5'-methylphenyl]benzotriazole, 2,2'-methylenebis[4-(1,1,3,3-tetramethylbutyl)-6-(2H-benzotriazole-2-yl)phenol], 2-[2-hydroxy-3,5-bis(α,α-dimethylbenzyl)phenyl]-2H-benzotriazole, 2-(2-hydroxy-4-octyloxyphenyl)-2H-benzotriazole, and 2-(2H-benzotriazole-2-yl)-4-methyl-6-(3,4,5,6-tetrahydrophthalimidylmethyl)phenol; benzophenone-based ultraviolet absorbing agents such as 2-hydroxy-4-methoxybenzophenone, 2,4-dihydroxybenzophenone, 2,2'-dihydroxy-4-methoxybenzophenone, 2,2'-dihydroxy-4,4'-dimethoxybenzophenone, 2-hydroxy-4-n-octoxybenzophenone, 2,2',4,4'-tetrahydroxybenzophenone, 4-dodecyloxy-2-hydroxybenzophenone, a 3,5-di-t-butyl-4-hydroxybenzoylbenzoic acid n-hexadecyl ester, 1,4-bis(4-benzoyl-3-hydroxyphenoxy)butane, 1,6-bis(4-benzoyl-3-hydroxyphenoxy)hexane; and cyanoacrylate-based ultraviolet absorbing agents represented by ethyl-2-cyano-3,3-diphenylacrylate.

Examples of the commercially available ultraviolet absorbing agent include TINUVIN 320, TINUVIN 328, TINUVIN 234, TINUVIN 1577, TINUVIN 622, and IRGANOX series, manufactured by BASF Japan Ltd.; ADEKA STAB LA31 manufactured by ADEKA Corporation; and SEESORB 102, SEESORB 103, and SEESORB 501, manufactured by SHIPRO KASEI KAISHA, Ltd. It is noted that the above-described "TINUVIN", "IRGANOX", "ADEKA STAB", and "SEESORB" are all registered trade names.

In a case where the above radio wave absorber contains an ultraviolet absorbing agent, the content of the ultraviolet absorbing agent in the radio wave absorber is not particularly limited, and it is, for example, preferably 0.2% by mass to 10% by mass with respect to the total mass of the radio wave absorber.

The content of the ultraviolet absorbing agent in the above radio wave absorber is preferably set to 0.2% by mass or more with respect to the total mass of the radio wave absorber from the viewpoint of improving weather fastness.

In a case where the content of the ultraviolet absorbing agent in the radio wave absorber is 10% by mass or less with respect to the total mass of the radio wave absorber, the decrease in mechanical strength and the occurrence of blooming tend to be capable of being suppressed.

### -- Singlet oxygen quencher --

In a case where the above radio wave absorber contains a singlet oxygen quencher, the content of the singlet oxygen quencher in the radio wave absorber is not particularly limited, and it is, for example, preferably 0.2% by mass to 10% by mass with respect to the total mass of the radio wave absorber.

The content of the singlet oxygen quencher in the above radio wave absorber is preferably made be 0.2% by mass or more with respect to the total mass of the radio wave absorber from the viewpoint of improving weather fastness.

In a case where the content of the singlet oxygen quencher in the radio wave absorber is 10% by mass or less with respect to the total mass of the radio wave absorber, the decrease in mechanical strength and the occurrence of blooming tend to be capable of being suppressed.

In a case of containing a light stabilizer, the above radio wave absorber may contain only one kind of light stabilizer or may contain two or more kinds of light stabilizers.

### <Production method for radio wave absorber>

The production method for the radio wave absorber of the present disclosure is not particularly limited. A composition that is used for preparing a radio wave absorber (hereinafter, also referred to as a "composition for forming a radio wave absorber") can be prepared by a publicly known method using a magnetic powder, a binder, and, as necessary, a solvent, other additives, and the like. For example, the radio wave absorber can be a molded product formed by molding the composition for forming a radio wave absorber. For example, the composition for forming a radio wave absorber can be prepared as a kneaded material by kneading, while heating, a mixture of a magnetic powder, a binder, and, as necessary, a solvent, additives. The kneaded material can be obtained in any shape, for example, an aggregated shape, a pellet, or a filament that can be used for a three-dimensional (3D) printer. The kneaded material is molded into a desired shape by a publicly known molding method such as extrusion molding, press molding, injection molding, in-mold forming, or 3D print shaping, whereby a radio wave absorber (a molded product) can be obtained. The shape of the radio wave absorber is not particularly limited and may be any shape such as a plate shape or a linear shape. The "plate shape" includes a sheet shape and a film shape. The plate-shaped radio wave absorber can also be called a radio wave absorbing plate, a radio wave absorbing sheet, a radio wave absorbing film, or the like. The radio wave absorber may be a radio wave absorber having a single composition (for example, a single-layer radio wave absorbing plate) or a combination of two or more portions having different compositions (for example, a laminate). In addition, the radio wave absorber may have a planar shape, may have a three-dimensional shape, or may be a combination of a portion having a planar shape and a portion having a three-dimensional shape. Examples of the planar shape include a sheet shape and a film shape. Examples of the three-dimensional shape include a tubular shape (a cylindrical shape, rectangular tubular shape, or the like), a horn shape, and a box shape (for example, at least one of the surfaces thereof is open).

For example, the thickness of the radio wave absorber is preferably 20 mm or less, more preferably 10 mm or less, and still more preferably 5 mm or less, from the viewpoint of easiness of handling. From the viewpoint of mechanical properties, the thickness is preferably 1 mm or more and more preferably 2 mm or more. In a case where the thickness of the radio wave absorber is adjusted, for example, the transmission attenuation amount can be adjusted. It is noted that in a case where the radio wave absorber is a laminate, the thickness means the total thickness of the radio wave absorber constituting the laminate. The thickness of the radio wave absorber is a value measured using a digital length measuring machine and, specifically, is an arithmetic average of the measured values measured at nine locations which are randomly selected.

The composition for forming a radio wave absorber may contain or may not contain a solvent. In a case where the composition for forming a radio wave absorber contains a solvent, the solvent is not particularly limited, and examples thereof include water, an organic solvent, and a mixed solvent of water and an organic solvent.

Examples of the organic solvent include alcohols such as methanol, ethanol, n-propanol, i-propanol, and methoxypropanol, ketones such as acetone, methyl ethyl ketone, and cyclohexanone, tetrahydrofuran, acetonitrile, ethyl acetate, and toluene. Among these, the solvent is preferably ketones and more preferably cyclohexanone from the viewpoint of drying rate. In a case where the composition for forming a radio wave absorber contains a solvent, the content of the solvent in the composition is not particularly limited and may be determined depending on the production method for a radio wave absorber.

The composition for forming a radio wave absorber can be prepared by mixing the above components. The mixing method is not particularly limited, and examples thereof include a method of mixing by stirring. As the stirring unit, a publicly known stirring device can be used. Examples of the stirring device include mixers such as a paddle mixer and an impeller mixer. The stirring time may be set depending on the kind of the stirring device, the composition of a composition for forming a radio wave absorber, or the like.

Examples of one form of the production method for the radio wave absorber include a method of molding the composition for forming a radio wave absorber into a desired shape by a publicly known molding method as exemplified above.

In addition, examples of another form of the production method for the radio wave absorber include a method of applying the composition for forming a radio wave absorber onto a support and producing the radio wave absorber as a radio wave absorbing layer. The support that is used here may be removed before the radio wave absorber is incorporated into an article to which the radio wave absorbability should be imparted or may be incorporated into the article together with the radio wave absorber without being removed.

The support is not particularly limited, and a well publicly known support can be used. Examples of the support include a metal plate (a plate of metal such as aluminum, zinc, or copper), a glass plate, a plastic sheet [a sheet of polyester (polyethylene terephthalate, polyethylene naphthalate, or polybutylene terephthalate), polyethylene (linear low-density polyethylene, low-density polyethylene, or high-density polyethylene), polypropylene, polystyrene, polycarbonate, polyimide, polyamide, polyamide imide, polysulfone, polyvinyl chloride, polyacrylonitrile, polyphenylene sulfide, polyether imide, polyether sulfone, polyvinyl acetal, or an acrylic resin], a plastic sheet on which the metal exemplified in the metal plate described above is laminated or vapor-deposited. The plastic sheet is preferably biaxially stretched. The shape, structure, size, and the like of the support can be appropriately selected.

Examples of the shape of the support include a plate shape. The structure of the support may be a monolayer structure or a laminated structure of two or more layers. The size of the support can be appropriately selected depending on the size of the radio wave absorber. The thickness of the support is generally approximately 0.01 mm to 10 mm, for example, preferably 0.02 mm to 3 mm and more preferably 0.05 mm to 1 mm, from the viewpoint of handleability.

The method of applying a composition for forming a radio wave absorber on a support is not particularly limited, and examples thereof include methods using a die coater, a knife coater, an applicator. The method of drying the coating film formed by applying a composition for forming a radio wave absorber is not particularly limited, and examples thereof include a method using a publicly known heating device such as an oven. The drying temperature and the drying time are not particularly limited. For example, the drying temperature can be in a range of 70°C to 90°C, and the drying time can be in a range of 1 hour to 3 hours.

The radio wave absorber can be incorporated into various articles to which radio wave absorbability is desired to be imparted. For example, the plate-shaped radio wave absorber can be incorporated into an article in any form as it is or by being bent at any portion. In addition, it can be adjusted to a desired shape by injection molding or the like to be incorporated into an article.

By the way, the on-vehicle radar, which has been attracting attention in recent years, is a radar that uses radio waves in the millimeter wave frequency band. The millimeter wave is an electromagnetic wave having a frequency of 30.0 GHz to 300.0 GHz. The radio wave absorber is suitable, for example, as a radio wave absorber that is incorporated on a front side (an incident side of the radio wave incident from the outside) of the radio wave transmitting and receiving unit in the on-vehicle radar in order to reduce the side lobe of the on-vehicle millimeter-wave radar.

In addition, the radio wave absorber can also be incorporated into a radio wave absorbing article that is used in the field of wireless technology such as a motion sensor. The radio wave absorber is suitable as a radio wave absorber for improving recognition accuracy by removing unnecessary radio waves in wireless equipment such as an internal sensor of a cellular phone and a biological information sensor. Such a radio wave absorber can be suitably used, for example, in a radio wave absorbing article for a band of 55.0 to 66.0 GHz. The radio wave absorbing article is an article having radio wave absorbability to radio waves of one or more frequencies, and in a case where a radio wave absorber is incorporated into the article as at least a part thereof, the above radio wave absorbability can be obtained. The radio wave absorbing article for a band of 55.0 to 66.0 GHz is an article having radio wave absorbability to radio waves of one or more frequencies in a frequency band of 55.0 to 66.0 GHz. Examples of such an article include the above-described various wireless equipment. In a case where the radio wave absorber is incorporated into such a radio wave absorbing article, unnecessary radio waves can be removed, and thus the recognition accuracy can be improved.

In addition, the bandwidth may be wide-banded depending on the kind of radar in which the radio wave absorber is used. For example, a radar for a 60 GHz band may be used in a 7.0 GHz bandwidth in a range of 57.0 to 64.0 GHz. For a use application to a radar having such a wideband bandwidth, a plurality of kinds of magnetic powders can be mixed to prepare a radio wave absorber that can be compatible with bandwidth widening, and/or a plurality of kinds of radio wave absorbers can be also mixed to prepare a radio wave absorber that can be compatible with bandwidth widening.

### [Radio wave absorbing article]

One aspect of the present invention relates to a radio wave absorbing article including the radio wave absorber. Specific examples of the radio wave absorbing article include an on-vehicle radar. Specific examples thereof include wireless equipment such as an internal sensor of a cellular phone and a biological information sensor. In addition, in one form, the radio wave absorbing article can be a radio wave absorbing article in a band of 55.0 GHz to 66.0 GHz. It suffices that the radio wave absorbing article includes the radio wave absorber according to one aspect of the present invention. Other configurations of the radio wave absorbing article are not particularly limited, and a publicly known technique related to the radio wave absorbing article can be applied.

The radio wave absorber is such that the inclination of the peak frequency, which is determined as described above, is 40.0 MHz/°C or less with respect to the temperature described above. Therefore, variations in transmission attenuation characteristics in association with temperature change are small, and thus favorable transmission attenuation characteristics can be exhibited in a wide temperature range. As a result, a radio wave absorbing article including the radio wave absorber can continue to exhibit excellent performance even in a case of being applied to a use application (for example, an on-vehicle use application) in which the radio wave absorbing article is used in an environment in which the radio wave absorber may be exposed to a temperature change.

### Examples

Hereinafter, the present invention will be described based on Examples. However, the present invention is not limited to the embodiments shown in Examples. Unless otherwise specified, steps and evaluations described below were carried out in an environment of the ambient air atmosphere. In addition, the steps and evaluations in the following description were carried out at an atmospheric temperature of 23°C ± 1°C, unless otherwise specified.

### [Production of magnetic powder 1]

15.72 g of strontium carbonate [SrCO₃], 81.49 g of α-iron (III) oxide [α-Fe₂O₃], and 15.72 g of aluminum oxide [Al₂O₃] were weighed, charged into a paint shaker together with 500 g of zirconia beads (bead diameter: 0.5 mm) and 300 g of water, and subjected to a mixing treatment in a paint shaker for 3.5 hours to obtain a dispersion liquid.

After the mixing treatment, the dispersion liquid was recovered while separating the zirconia beads.

The recovered dispersion liquid was subjected to centrifugal separation to discard the supernatant liquid, and then dried in a heating furnace having a furnace temperature of 95°C for 12 hours to obtain a raw material mixture.

Next, the obtained raw material mixture was subjected to a pulverization treatment three times to obtain a powder, where the pulverization treatment was carried out for 30 seconds by using a mill (Absolute 3, manufactured by OSAKA CHEMICAL Co., Ltd.) and setting a variable speed dial to "maximum". Strontium chloride (SrCl₂) was dissolved in 100 mL of water to prepare a strontium chloride aqueous solution having a concentration of 10% by mass, which was subsequently added to the obtained powder and subjected to ultrasonic dispersion for 10 minutes. Then, drying was carried out in a heating furnace having a furnace temperature of 95°C for 12 hours, and further, pulverization was carried out with the above-described mill to obtain a pulverized material.

Next, the obtained pulverized material was sintered in a heating furnace having a furnace temperature of 1,250°C for 4 hours, and then the obtained sintered product was subjected to a pulverization treatment three times, where the pulverization treatment was carried out for 30 seconds by using the above mill and setting a variable speed dial to "5". Then, washing was carried out by an ultrasonic treatment until the electric conductivity reached 30 microsiemens (µS) or less, and then drying was carried out in a heating furnace having a furnace temperature of 95°C for 12 hours to obtain a magnetic powder.

Next, the obtained magnetic powder was subjected to an annealing treatment in a heating furnace having a furnace temperature of 1,000°C for 2 hours.

In this way, a magnetic powder 1 was obtained.

### [Production of magnetic powder 2]

A magnetic powder 2 was obtained according to the method described for the magnetic powder 1, except that the annealing treatment was not carried out.

### [Production of magnetic powder 3]

A magnetic powder 3 was obtained according to the method described for the magnetic powder 1, except that the pulverization conditions for the sintered product after sintering were reinforced. Specifically, a magnetic powder 3 was obtained according to the method described for the magnetic powder 1, except that the setting of the variable dial of the mill in the pulverization treatment of the sintered product after sintering was set to "maximum".

### [Production of magnetic powder 4]

A magnetic powder 4 was obtained according to the method described for the magnetic powder 3, except that the annealing treatment was not carried out.

### [Production of magnetic powder 5]

A magnetic powder 5 was obtained according to the method described for the magnetic powder 1, except that zirconia beads were not used in the mixing of the raw materials.

### [Checking of crystal structure]

The crystal structure of the magnetic material constituting each of the above magnetic powders was checked by X-ray diffraction analysis. As the measurement device, X'Pert Pro manufactured by PANalytical Co., Ltd., which is a powder X-ray diffractometer, was used. The measurement conditions are shown below.

### - Measurement conditions -

X-ray source: CuKα ray
[Wavelength: 1.54 Å (0.154 nm), output: 40 mA, 45 kV]
Scan range: 20° <2θ < 70°
Scan interval: 0.05°
Scan speed: 0.33 °/min

As a result of the X-ray diffraction analysis, it has been confirmed that all the magnetic powders have a magnetoplumbite-type crystal structure and are a single-phase powder of a magnetoplumbite-type hexagonal ferrite that does not include a crystal structure other than the magnetoplumbite-type crystal structure.

### [Checking of composition]

The composition of the magnetic material that constitutes each of the above magnetic powders was checked by the high frequency inductively coupled plasma emission spectroscopy analysis. Specifically, the checking was carried out by the following method.

A container (a beaker) containing 12 mg of the magnetic powder and 10 mL of an aqueous solution of hydrochloric acid of a concentration of 4 mol/L was held on a hot plate at a set temperature of 120°C for 3 hours to obtain a dissolution solution. 30 mL of pure water was added to the obtained dissolution solution, which is then filtered using a membrane filter having a filter pore diameter of 0.1 µm. Elemental analysis of the filtrate obtained as described above was carried out using a high frequency inductively coupled plasma emission spectrometer [ICPS-8100, manufactured by Shimadzu Corporation]. Based on the obtained elemental analysis results, a content of each atom with respect to 100% by atom of the iron atom was obtained. Then, based on the obtained content, the composition of the magnetic material was checked. As a result, it was confirmed that the compositions of the magnetic powders 1 to 5 are compositions in which A in Formula 1 is Sr and x is 1.65.

### [Examples 1 to 4 and Comparative Examples 1 to 3]

### <Preparation of radio wave absorber>

The magnetic powder shown in Table 1 was introduced into a kneader (Labo Plastomill manufactured by Toyo Seiki Seisaku-sho, Ltd.) together with a binder (an olefin-based thermoplastic elastomer (TPO) [MILASTOMER (registered trade name) 7030NS manufactured by Mitsui Chemicals, Inc.]) and kneaded for 20 minutes at a set temperature of the kneader of 200°C to obtain a composition for forming a radio wave absorber (an aggregated kneaded material), where the magnetic powder has such an amount that the volume filling rate of the magnetic powder in the prepared radio wave absorber was the value shown in Table 1.

The obtained composition for forming a radio wave absorber was press-molded using a heating press machine to obtain a radio wave absorber (a radio wave absorbing sheet) as a plate-shaped molded product having a square plane, one side of which had a length of 100 mm.

For each of the radio wave absorbers in Examples and Comparative Examples, the thickness was determined as the arithmetic average of the measured values measured at nine locations which were randomly selected, using a digital length measuring machine [Litematic (registered trade name) VL-50A manufactured by Mitutoyo Corporation]. All the thicknesses of the above radio wave absorbers were 2 mm.

### <Transmission attenuation amount and reflection attenuation amount>

The transmission attenuation amount (unit: dB) and the reflection attenuation amount (unit: dB) of each of the above radio wave absorbers were measured by the following method.

As the measurement device, a vector network analyzer (product name: N5225B) manufactured by Keysight Technologies and a horn antenna (product name: RH12S23) manufactured by KEYCOM Corp were used to measure an S parameter with a free space method by setting an incidence angle to 0°, a sweep frequency to 60 GHz to 90 GHz, and a sweep interval of 0.05 GHz, with one plane of each of the above radio wave absorbers being directed toward the incident side.

The reflection attenuation amount was measured at a measurement temperature of "+25°C". S11 of the S parameter at a frequency of 76.5 GHz is shown in Table 1 as a reflection attenuation amount at the measurement temperature of "+25°C".

Regarding the transmission attenuation amount, the measurement was carried out at each of measurement temperatures of "-30°C", "-20°C", "+23°C", "+25°C", "+40°C", "+60°C", "+80°C", and "+100°C". S21 of the S parameter at a frequency of 76.5 GHz at each of the measurement temperatures of "-30°C", "+25°C", and "+80°C" is shown in Table 1 as the transmission attenuation amount at each measurement temperature.

The inclination of the peak frequency with respect to the temperature was calculated as described from the measurement results obtained at the measurement temperatures of "-20°C", "+23°C", "+40°C", "+60°C", "+80°C", and "+100°C". The calculated values are shown in Table 1.

### <Deflection amount, elastic modulus, and 20% tensile permanent strain>

For each of the radio wave absorbers of Examples and Comparative Examples, the deflection amount, the elastic modulus, and the 20% tensile permanent strain were determined according to the methods described above. The obtained results are shown in Table 1. In the measurement of the elastic modulus, a tensile tester AGX-V manufactured by Shimadzu Corporation was used as a tensile tester.

**[Table 1]**

| | | Example 1 | Example 2 | Comparative Example 1 | Comparative Example 2 | Comparative Example 3 | Example 3 | Example 4 |
|---|---|---|---|---|---|---|---|---|
| Magnetic powder | | Magnetic powder 1 | Magnetic powder 2 | Magnetic powder 3 | Magnetic powder 3 | Magnetic powder 4 | Magnetic powder 5 | Magnetic powder 1 |
| Transmission attenuation amount (S21), -30°C | dB | 16.7 | 16.0 | 15.1 | 16.0 | 14.5 | 15.7 | 18.9 |
| Transmission attenuation amount (S21), +25°C | dB | 19.4 | 19.5 | 19.4 | 21.2 | 19.5 | 19.4 | 22.5 |
| Transmission attenuation amount (S21), +80°C | dB | 16.0 | 15.4 | 14.6 | 15.4 | 140 | 15.5 | 18.1 |
| Reflection attenuation amount (S11), +25°C | dB | 9.0 | 9.0 | 8.8 | 7.9 | 9.0 | 7.6 | 8.5 |
| Inclination of peak frequency with respect to temperature | MHz/°C | 34.6 | 38.8 | 41.8 | 41.8 | 44.5 | 37.0 | 34.6 |
| Volume filling rate of magnetic powder | % by volume | 30 | 30 | 30 | 37 | 30 | 42 | 33 |
| Deflection amount | mm | 7.0 | 7.0 | 7.0 | 8.5 | 7.0 | 11.0 | 7.7 |
| Elastic modulus | MPa | 350 | 350 | 350 | 550 | 350 | 750 | 440 |
| 20% tensile permanent strain | % | 1.5 | 1.5 | 1.5 | 1.9 | 1.5 | 2.1 | 1.7 |

From the measurement results of the transmission attenuation amounts at various measurement temperatures shown in Table 1, it can be confirmed that the radio wave absorbers of Examples 1 to 4 in which the inclination of the peak frequency with respect to the temperature is 40.0 MHz or less have exhibited favorable transmission attenuation characteristics in a wide temperature range as compared with the radio wave absorbers of Comparative Examples 1 to 3.

One aspect of the present invention is useful in the technical field of carrying out various automatic driving controls such as automatic driving control of an automobile, and the wireless technical field such as a motion sensor field.

## Claims

1. A radio wave absorber comprising:
a magnetic powder; and
a binder,
wherein an inclination of a peak frequency with respect to a temperature is 40.0 MHz/°C or less.

2. The radio wave absorber according to claim 1,
wherein a volume filling rate of the magnetic powder in the radio wave absorber is 35% by volume or less.

3. The radio wave absorber according to claim 1,
wherein an elastic modulus is 500 MPa or less.

4. The radio wave absorber according to claim 1,
wherein the magnetic powder includes a powder of a hexagonal ferrite.

5. The radio wave absorber according to claim 4,
wherein the hexagonal ferrite is a substitution-type hexagonal ferrite.

6. The radio wave absorber according to claim 5,
wherein the substitution-type hexagonal ferrite is a magnetoplumbite-type hexagonal ferrite having a composition represented by Formula 1,
Formula 1 AFe₍₁₂₋ₓ₎AlₓO₁₉
in Formula 1, A represents one or more kinds of atoms selected from the group consisting of Sr, Ba, Ca, and Pb, and x satisfies 0.50 ≤ x ≤ 8.00.

7. The radio wave absorber according to claim 6,
wherein an atom represented by A in Formula 1 includes Sr.

8. The radio wave absorber according to claim 1,
wherein a volume filling rate of the magnetic powder in the radio wave absorber is 35% by volume or less,
an elastic modulus of the radio wave absorber is 500 MPa or less,
the magnetic powder includes a powder of a substitution-type hexagonal ferrite, and
the substitution-type hexagonal ferrite is a magnetoplumbite-type hexagonal ferrite having a composition represented by Formula 1,
Formula 1 AFe₍₁₂₋ₓ₎AlₓO₁₉
in Formula 1, A represents one or more kinds of atoms selected from the group consisting of Sr, Ba, Ca, and Pb, an atom represented by A includes Sr, and x satisfies 0.50 ≤ x ≤ 8.00.

9. A radio wave absorbing article comprising:
the radio wave absorber according to any one of claims 1 to 8.
